(19) Europäisches Patentamt
European Patent Office
Office européen des brevets

(11) **EP 1 020 041 B1**

## (12) EUROPEAN PATENT SPECIFICATION

(45) Date of publication and mention
of the grant of the patent:
**07.04.2004 Bulletin 2004/15**

(21) Application number: **97909848.0**

(22) Date of filing: **30.09.1997**

(51) Int Cl.$^7$: **H04B 7/005**

(86) International application number:
**PCT/US1997/016270**

(87) International publication number:
**WO 1999/029047 (10.06.1999 Gazette 1999/23)**

(54) **METHOD AND APPARATUS FOR INCREASING RECEIVER IMMUNITY TO INTERFERENCE**

VERFAHREN ZUM ERHÖHEN DER STÖRUNGSIMMUNITÄT EINES EMPFÄNGERS

PROCEDE ET APPAREIL PERMETTANT D'AUGMENTER L'IMMUNITE D'UN RECEPTEUR VIS-A-VIS DES INTERFERENCES

(84) Designated Contracting States:
**AT BE CH DE DK ES FI FR GB GR IE IT LI LU MC NL PT SE**

(43) Date of publication of application:
**19.07.2000 Bulletin 2000/29**

(73) Proprietor: **QUALCOMM INCORPORATED**
**San Diego, CA 92121-1714 (US)**

(72) Inventors:
• **HUTCHISON, James, A., IV**
**San Diego, CA 92123 (US)**

• **WIECK, Chris, P.**
**San Diego, CA 92111 (US)**

(74) Representative: **Dunlop, Hugh Christopher et al**
**R G C Jenkins & Co.**
**26 Caxton Street**
**London SW1H 0RJ (GB)**

(56) References cited:
**EP-A- 0 342 671       EP-A- 0 366 485**
**GB-A- 2 223 146**

**Description**

The present invention relates to radio communications. More particularly, the present invention relates to improving a communication receiver's immunity to interference.

There are presently multiple types of cellular radiotelephone systems operating. These systems include the advanced mobile phone system (AMPS) and the two digital cellular systems: time division multiple access (TDMA) and code division multiple access (CDMA). The digital cellular systems are being implemented to handle capacity problems that AMPS is experiencing.

All the cellular radiotelephone systems operate by having multiple antennas covering a geographic area. The antennas radiate into an area referred to in the art as a cell. The AMPS cells are separate and distinct from the CDMA cells. This makes it likely that the antenna for one system's cell may be located in a cell of another system. Likewise, within a particular system (AMPS, CDMA, and TDMA), there are two service providers within a given area. These providers often choose to place cells in different geographical locations from their competitor, hence there are situations where a radiotelephone on system 'A' might be far away from the nearest system 'A' cell while close to a system 'B' cell. This situation means that the desired receive signal will be weak in the presence of strong multi-tone interference.

This intermixing of system antennas can cause problems for a mobile radiotelephone that is registered in one system, such as the CDMA system, and travels near another system's antenna, such as an AMPS antenna. In this case, the signals from the AMPS antenna can interfere with the CDMA signals being received by the radiotelephone due to the proximity of the radiotelephone with the AMPS cell or the higher power of the AMPS forward link signal.

The multi-tone interference encountered by the radiotelephone from the AMPS signals creates distortion products or spurs. If these spurs fall in the CDMA band used by the radiotelephone, they can degrade receiver and demodulator performance.

It is frequently the case in an AMPS system for the carriers (A and B bands) to 'jam' the competitor system unintentionally. The goal of the cellular carrier is to provide a high signal to noise ratio for all the users of their system by placing cells close to the ground, or near their users, and radiating the FCC power limit for each AMPS channel. Unfortunately, this technique provides for better signal quality for the carrier's system at the expense of interfering with the competitor's system.

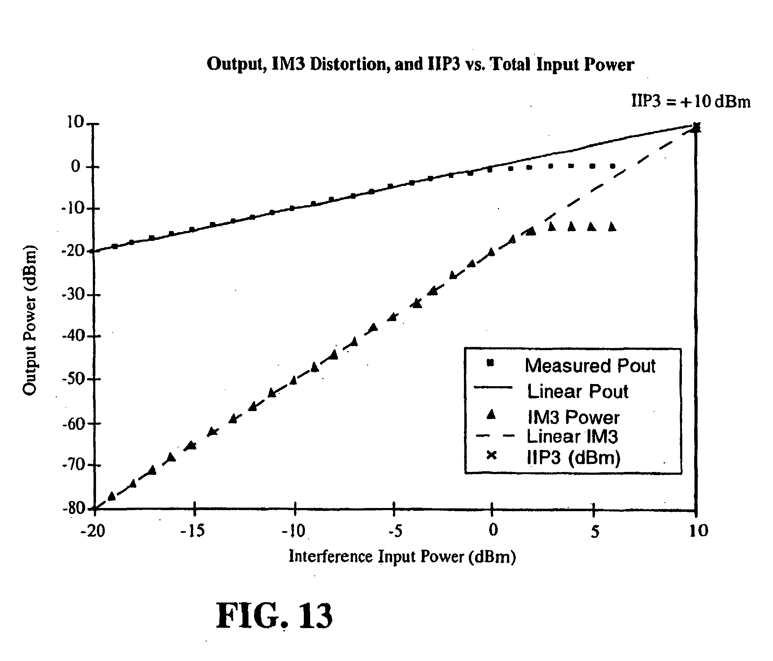

Intermodulation distortion, such as that caused by the above situations, is defined in terms of the peak spurious level generated by two or more tones injected into a receiver. Most frequently, the third-order distortion level is defined for a receiver in terms of a third-order input intercept point or IIP3. IIP3 is defined as the input power (in the form of two tones) required to create third order distortion products equal to the input two tone power. As shown in FIG. 13, IIP3 can only be linearly extrapolated when a non-linear element, such as an amplifier, is below saturation.

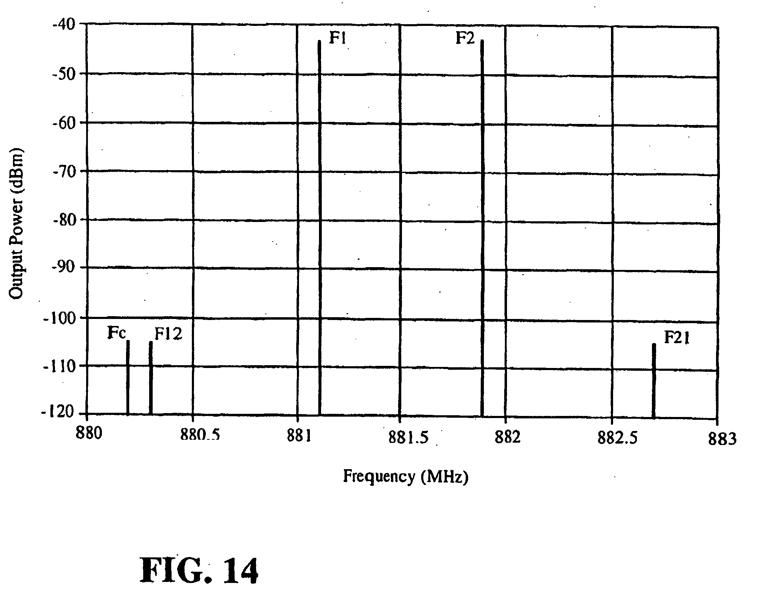

As shown in FIG. 14, third-order distortion products occur when two tones are injected in a receiver. Tone #1 is at frequency f1 at power level P1 in dBm. Tone #2 is at frequency f2 at power level P2 in dBm. Typically P2 is set to equal P1. Third-order distortion products will be created at frequencies 2xf1 - f2 and 2xf2 - f1 at power levels P12 and P21 respectively. If P2 is set to equal P1, then spurious products should be equal, or P12 and P21 should be equal. Signal fc is injected at power level Pc to show that the added distortion is equal to a low level signal in this case. If there is a filter that filters out f1, f2 and f21 after the distortion is created, the power at f12 will still interfere with the signal power at fc. In example FIG. 14, for a CDMA application, the goal is that the intermod P12 should be equal to the signal power of -105 dBm for a total two tone power of -43 dBm, so the IIP3 must be > -9 dBm.

As is well known in the art, IIP3 for a single non-linear element is defined as the following:

$$IIP3 = + P_{in} \text{ (dBm)}$$

$$\text{If } P_1 = P_2, \text{ then } P_{in} = P_1 + 3 \text{ dB or } P_2 + 3 \text{ dB (dBm)}$$

and

$$IM3 = P_1 - P_{12} = P_2 - P_{21} = P_2 - P_{12} = P_1 - P_{21} \text{ (dB)}$$

For cascaded IIP3, where more non-linear elements are used, the equation is as follows:

$$IIP3 = -10*\log10[10^{(Gain - element IIP3)/10} + 10^{(-IIP3 \text{ of previous stages})/10}]$$

where: Gain = gain to element input.

Therefore, one way to improve the cascaded IIP3 of a receiver is to lower the gain before the first non-linear element. In this case, the LNA and mixer limit IIP3. However, another quantity needs to be defined that sets the sensitivity or lowest receive signal level without interference. This quantity is referred to in the art as the noise figure (NF). If the gain of the receiver is reduced to improve IIP3 (and interference immunity), the NF (and sensitivity to small desired signals) is degraded.

The Element NF is defined as the following:

$$\text{Element NF} = \frac{S_i}{N_i} - \frac{S_o}{N_o} \text{ (dB)},$$

where:

$\frac{Si}{Ni}$ is the input signal to noise ratio in dB, and

$\frac{S_o}{N_o}$ is the output signal to noise ratio in dB.

For elements in cascade in a receiver, the equation is as follows:

$$\text{Cascaded NF} = 10*\log10\left[10^{(NFi/10)} + \frac{10^{(NFc/10)} - 1}{10^{(Gain/10)}}\right],$$

where:

NFe equals the noise figure of the element,
NFi equals the cascaded noise figure up to the element, and
Gain equals the running gain up to the element.

The 'best' cascaded NF can be achieved if the gain up to the element is maximized, this equation is in contradiction to the requirement for the 'best' cascaded IIP3. For a given element by element and receiver NF and IIP3, there are a limited set of gain values for each element that meet all of the requirements.

Typically, a receiver is designed with NF and IIP3 as predefined constants, as both of these quantities set the receiver's dynamic range of operation with and without interference. The gain, NF, & IIP3 of each device are optimized based on size, cost, thermal, quiescent and active element current consumption. In the case of a dual-mode CDMA/FM portable cellular receiver, the CDMA standard requires a 9 dB NF at minimum signal. In other words, for CDMA mode, the sensitivity requirement is a 0 dB S/N ratio at -104 dBm. For FM mode, the requirement is a 4 dB S/N ratio at -116 dBm. In both cases, the requirements can be translated to a NF as follows:

$$NF = S \text{ (dBm)} - \frac{S}{N} - N_{therm} \text{ (dBm/Hz)} - \text{Signal BW (dB/Hz)},$$

where

S is the minimum signal power,

$\frac{S}{N}$ is the minimum signal to noise ratio,

$N_{therm}$ is the thermal noise floor (-174 dBm/Hz @ 290°K),

and Signal BW (dB/Hz) is the bandwidth of the signal.

Therefore,

$$\text{CDMA NF} = -104 \text{ dBm} - 0 \text{ dB} - (-174 \text{ dBm/Hz}) - 61 \text{ dB/Hz} = 9 \text{ dB},$$

$$FM\ NF = -116\ dBm - 4\ dB - (-174\ dBm/Hz) - 45\ dB/Hz = 9\ dB,$$

where

-61 dBm/Hz is the noise bandwidth for a CDMA channel
- 45 dBm/Hz is the noise bandwidth for a FM channel

However, the receiver's NF is only required when the signal is near the minimum level and the IIP3 is only required in the presence of interference or strong CDMA signals.

There are only two ways to provide coverage in the areas where the carrier is creating strong interference. One solution is to employ the same technique; i.e., co-locate their cells along with the competition's. Another solution is to improve the immunity of a receiver to interference. One way to improve the immunity is to increase the receiver current This is not a practical solution, however, for a portable radio that relies on battery power. increasing the current would drain the battery more rapidly, thereby decreasing the talk and standby time of the radiotelephone. There is a resulting need to minimize multi-tone interference in a radiotelephone without impacting the current consumption.

EP-A-0 342 671 relates to automatic gain control (AGC) delay on an integrated circuit. Circuitry is described for staggering the onset of gain reduction in a series of cascaded gain stages as a function of received signal strength. The staggering is effected by controlling the area ratio between corresponding components in two or more AGC control circuits whose topologies are otherwise identical.

GB-A-2 223 146 describes a radio transceiver capable of avoiding intermodulation distortion comprising an RF amplifier and a first frequency mixer which converts an amplified RF signal into a first IF signal and whose output may include intermodulation distortion. A secondary frequency mixer converts the output of the first frequency mixer into a second IF signal. An interference detector detects the intermodulation distortion by seeing if a beat is included in the second IF signal. Upon detection of intermodulation distortion, the gain or the RF amplifier is minimised to decrease or eliminate the intermodulation distortion. Responsive to the end of the conversation, the gain of the RF amplifier is maximised to increase the reception sensitivity. The RF amplifier gain may be periodically maximised after the detection of the intermodulation distortion. If no intermodulation distortion is detected during this gain maximised period, the gain is kept to a maximised value. If the intermodulation distortion is not decreased or eliminated even though the RF amplifier gain is minimised, the frequency used for communication may be changed.

EP-A-0 366 485 describes a communication system with adaptive transceivers to control intermodulation distortion. A transceiver determines the signal quality of a desired signal and the strength of all received signals. When the signal quality of the desired signal is low, and the signal strength of all received signals is high, the receiver is adapted to operate in a higher current mode, thereby minimising intermodulation distortion. Conversely, when the quality of the desired signal is low and the strength of all received signals is also low, or when the quality of the desired signal is above a threshold, the receiver operates in a lower current mode to conserve power and maximise battery lifetime.

Embodiments of the process of the present invention adjust the gain of a receive circuit, thereby improving a receiver's immunity to interference. The circuit has an LNA which amplifies the received signal. The receive signal power is controlled by enabling or disabling the LNA in response to the measured received signal power. The received power level is periodically compared to a threshold. When the received power level is greater than the threshold, the LNA is disabled. The LNA is re-enabled when the received power level is less than the threshold, and there are no significant intermodulation components detected. The intermodulation components are detected by briefly enabling the LNA and detecting the resultant change in the measured signal power. If the detected change is more than a predetermined amount, then there are significant intermodulation components present, and the LNA is not re-enabled. However, if the detected change is less than the predetermined amount, then there are not significant intermodulation components present, and the LNA is re-enabled.

Thus, according to a first aspect of the present invention, there is provided a method for adjusting the gain of a circuit as set forth in claim 1.

According to a second aspect, there is provided an apparatus for adjusting the gain of a circuit as set forth in claim 8.

Figure 1 shows a block diagram of an apparatus for increasing receiver immunity.

Figure 2 shows a block diagram of an alternate apparatus.

Figure 3 shows a block diagram of another alternate apparatus.

Figure 4 shows a block diagram of another alternate apparatus.

Figure 5 shows a plot of received RF input power versus carrier to noise ratio in accordance with the embodiment of Figure 7.

Figure 6 shows another plot of receive RF input power versus carrier to noise ratio in accordance with the embodiment of Figure 8.

Figure 7 shows a block diagram of an alternate embodiment of the present invention.

Figure 8 shows a plot of interference power vs signal power without using the apparatus of the present invention.

Figure 9 shows a plot of interference power vs signal power in accordance with the alternate embodiments of the apparatus of the present invention.

Figure 10 shows a block diagram of an alternate embodiment of the present invention.

Figure 11 shows a block diagram of another alternate embodiment of the present invention.

Figure 12 shows a block diagram of another alternate embodiment of the present invention.

Figure 13 shows a plot of non-linear transfer characteristics and distortion measurement.

Figure 14 shows a spectral description of distortion products.

Figure 15 shows a block diagram of a method for detecting the power of a received signal in accordance with an embodiment of the present invention.

Figure 16 shows a flow chart of the gain control process of an embodiment of the present invention.

Figure 17 shows a flow chart of an alternate embodiment of the gain control process of the present invention.

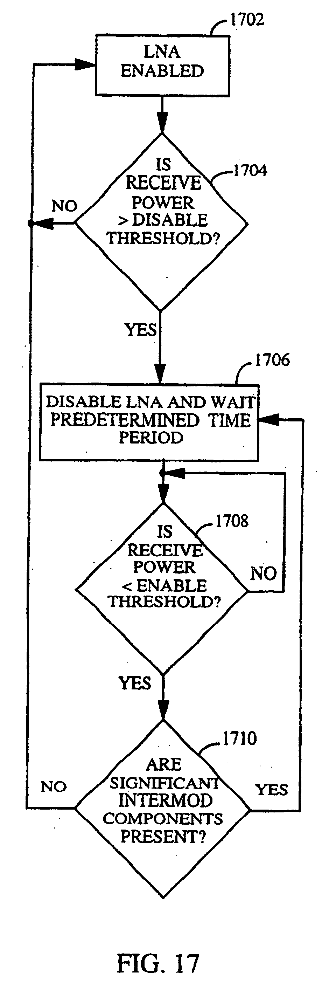

FIG. 17 shows a flow chart of an alternate embodiment of the gain control process of the present invention.


## DETAILED DESCRIPTION OF THE PREFERRED EMBODIMENTS

It is an objective of the present invention to vary the receiver NF and IIP3 for enhancing the IIP3 (or interference immunity) without compromising NF when necessary. This performance 'enhancement' is accomplished by varying the gain of the first active element in the receiver. The gain can be varied by varying the gain of the LNA over a continuous range or switching out the low noise amplifier with bypass switches.

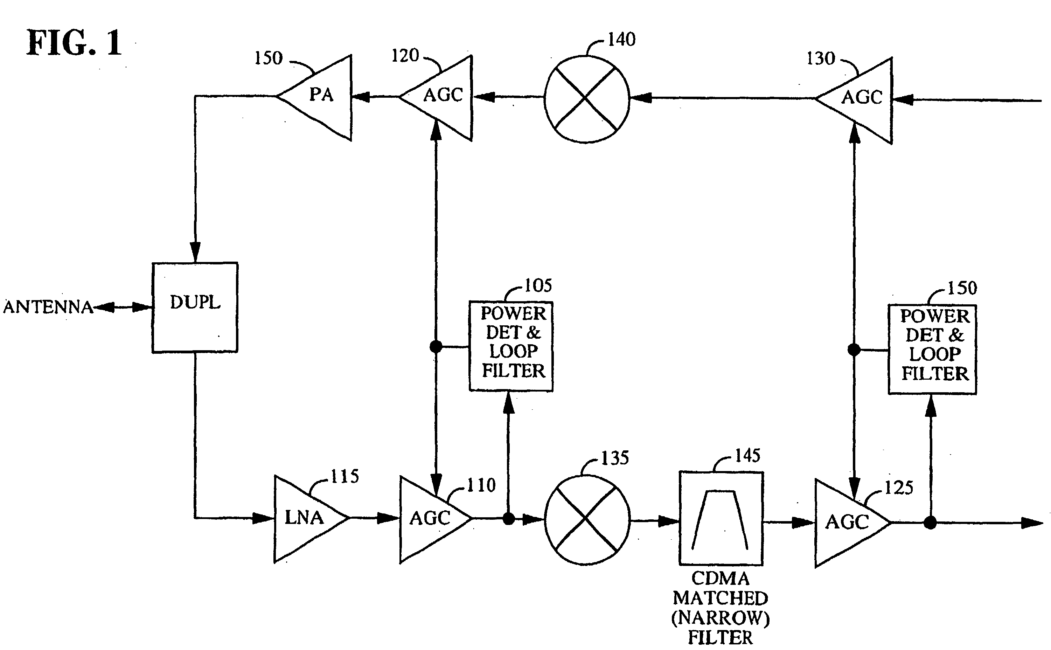

A block diagram of an apparatus for increasing receiver immunity invention is illustrated in FIG. 1. This apparatus involves adjusting the LNA **115** gain on a continuous basis using adjustable gain control (AGC) **110** at the receiver front end. The continuous AGC **110** at the front end also provides a linearity benefit at a minimum RF input level while the AGC **120** on the transmit side may reduce the IF AGC **125** and **130** requirements.

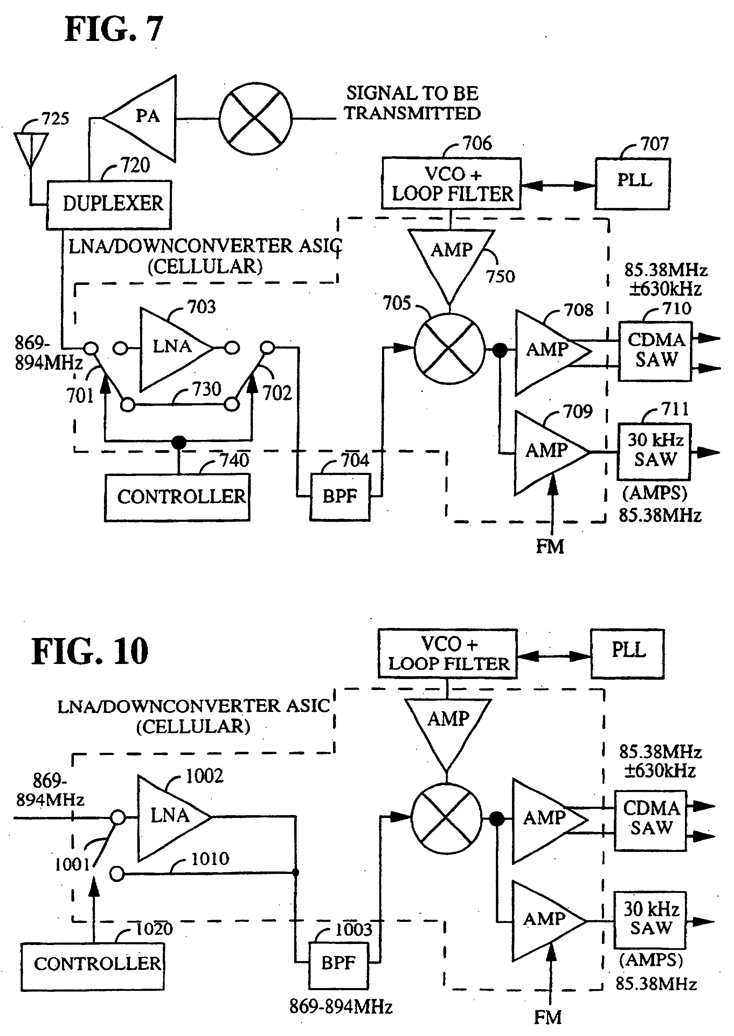

This apparatus detects the power output from the LNA **115**. The power detector **105** measures both the signal power and the jammer power together at RF. Using this apparatus, the power detector **105** can continuously decrease the LNA **115** gain at a lower received power than the -65 dBm of the subsequent "switched gain" embodiments of FIGs. 7, 10, 11 and 12.

The apparatus operates by the power detector **105** detecting the received signal and jammer power at RF. This detected power goes through a loop filter and is used to adjust the receive AGC **110**, thereby adjusting the intercept point of the receive components. The gain is decreased as the measured power increases and the gain is increased as the measured power decreases. This apparatus could also combine the LNA **115** and the AGC **110** to form a variable gain LNA, thus eliminating the need for the separate AGC **110** block. The power of the transmit AGC **120**, located before the power amplifier **150**, is adjusted in the same way as the receive AGC **110** in order to maintain the overall TX power level.

AGC amplifiers **125** and **130** are also located after the mixers **135** and **140** in order to adjust the gain after the jammers have been filtered out by the bandpass filter **145**. These AGC amplifiers **125** and **130** perform the normal CDMA AGC function of open loop power control, closed loop power control, and compensation. These IF AGCs **125** and **130** are required due to the wide dynamic range requirements for CDMA. Typically, these AGCs **125** and **130** have greater than 80 dB of gain range. The receive and transmit AGC **125** and **130** after the mixers are adjusted by another power detector **150** that measures the total power after the received signal is downconverted. The power detector **150** adjusts the AGCs **125** and **130** gain downward as the downconverted signal's power increases and adjusts the AGCs **125** and **130** gain upward as the downconverted signal's power decreases.

The received signals are preferably in the frequency band of 869-894 MHz. The transmitted signals are in the frequency band of 824-849 MHz. Alternate embodiments use different frequencies.

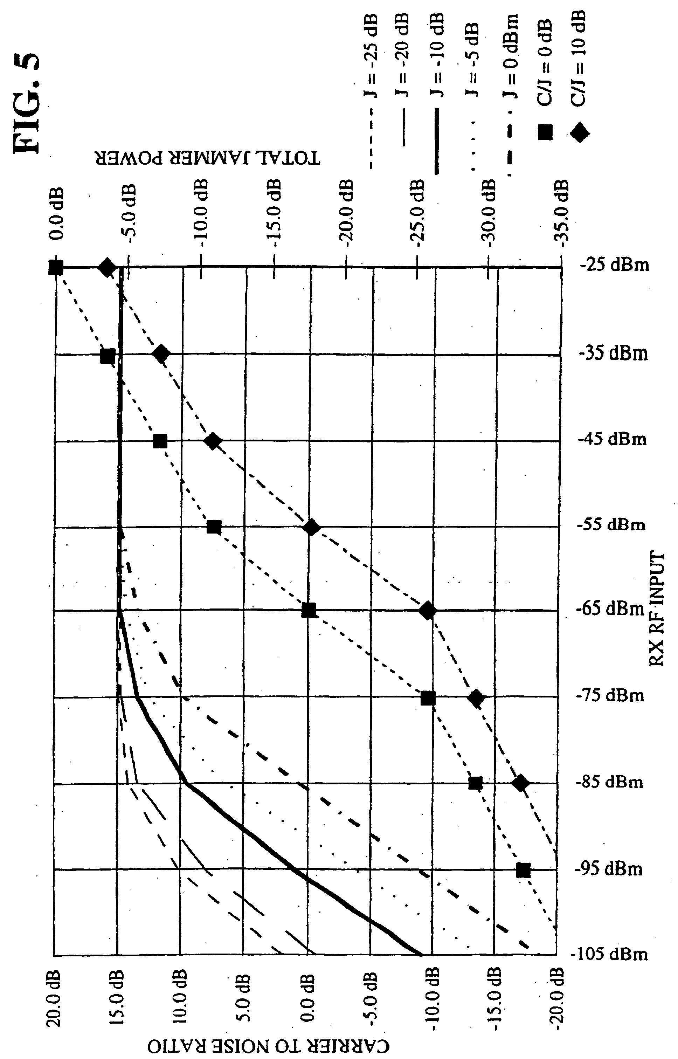

The plot illustrated in FIG. 5 shows the benefit of this AGC approach. The left hand y-axis shows the carrier over noise ratio versus receive input power parameterized by the jammer level. The right hand y-axis shows the total jammer power required for a constant C/J as a function of received input power. When the jammer is not present (-100 dBm), the radio operates as though there is no RF AGC. As the jammer is increased, the C/N is decreased, but the effective linearity is also increased. In this example, the RF dynamic range is 30 dB and the threshold, where the RF AGC becomes active, is at the point the jammer power is greater than -25 dBm.

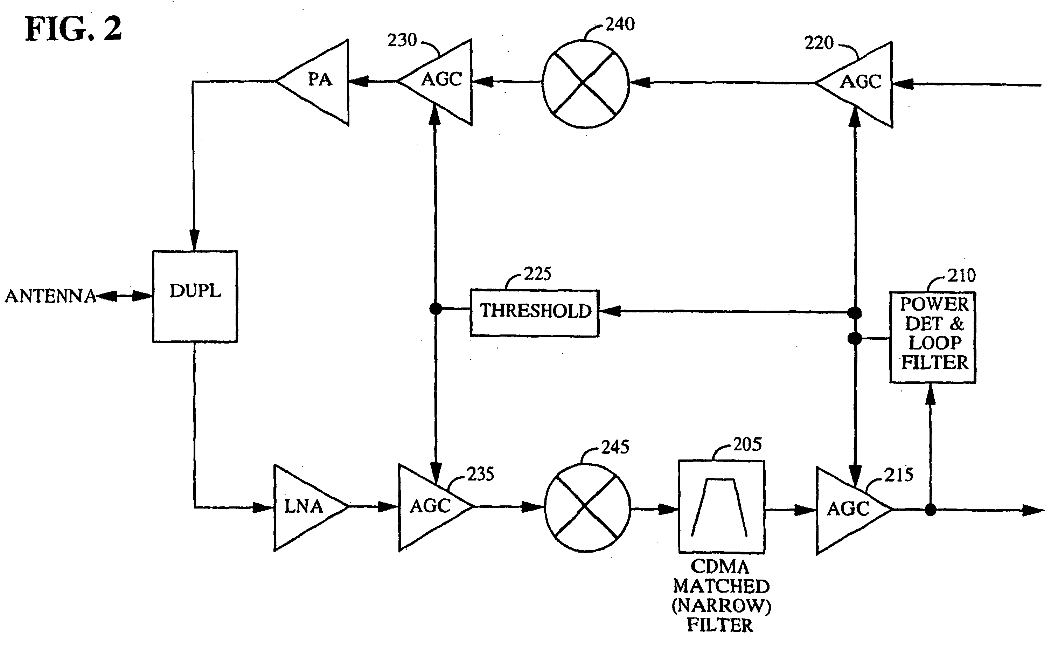

An alternate apparatus of the continuous gain adjustment is illustrated in FIG. 2. This embodiment first filters out the jammers with the bandpass filter **205** before the power detector **210** determines the power level of the downconverted signal. A threshold detector **225** determines when the signal power level reaches a certain point, -105 dBm in this apparatus, and then adjusts the AGCs **230** and **235** gain down when the signal power exceeds that power level.

The AGCs **230** and **235** gain is adjusted upward when the signal power level goes below this threshold. The gain of AGCs **215** and **220** after the mixers **240** and **245** is adjusted continuously without checking for a predetermined threshold of power, performing the normal CDMA AGC power control.

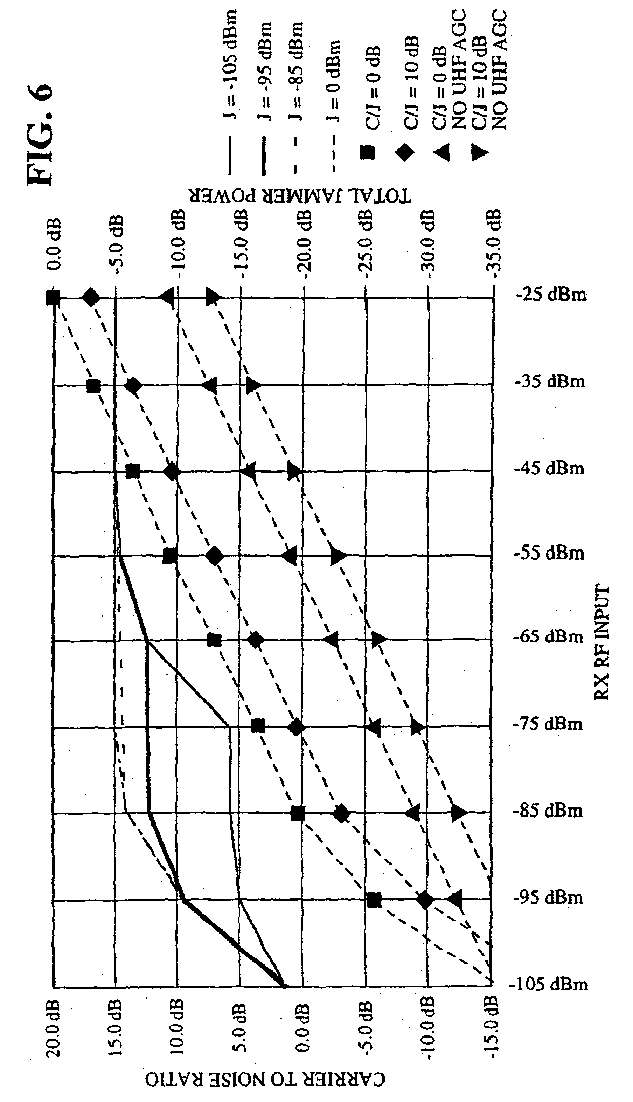

The plot of this embodiment is illustrated in FIG. 6. When the threshold is set at -105 dBm, the minimum receive RF level, the C/N does not increase as quickly as the case where there is no RF AGC. The advantage of this apparatus is that the linearity benefit begins at a very low RF input power, no receive RF power detector is needed, and the AGC loop detects signal power only. Hence, the AGC loop is a simpler design than detecting at RF power.

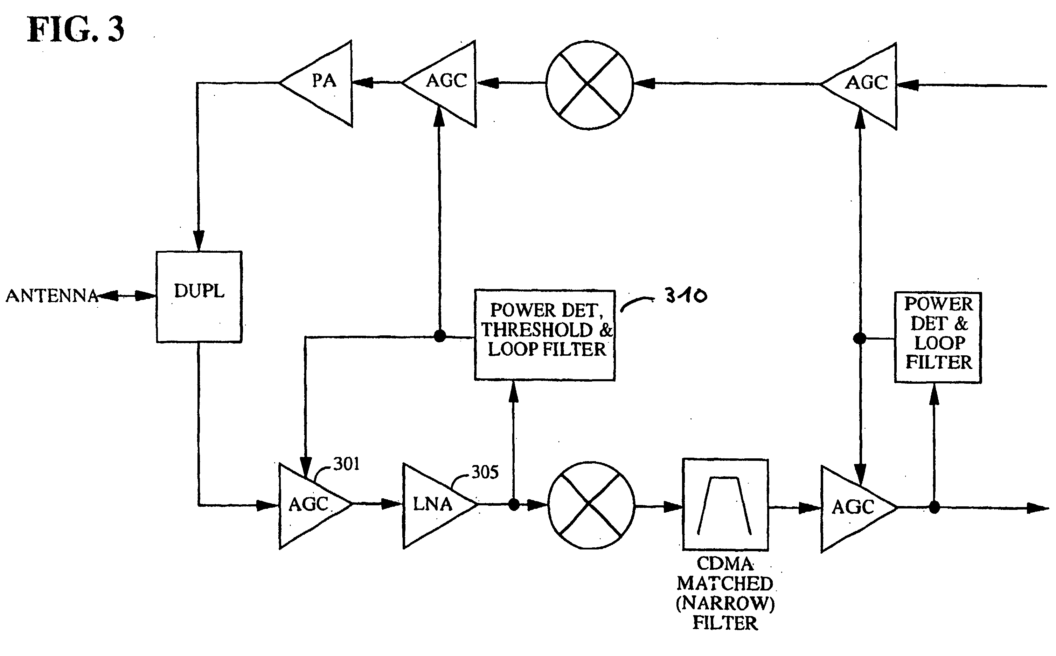

An embodiment of the present invention is illustrated in FIG. 3. This embodiment operates similarly to the embodiment of FIG. 1. The only difference being the placement of the AGC **301** prior to the LNA **305** in the receive path.

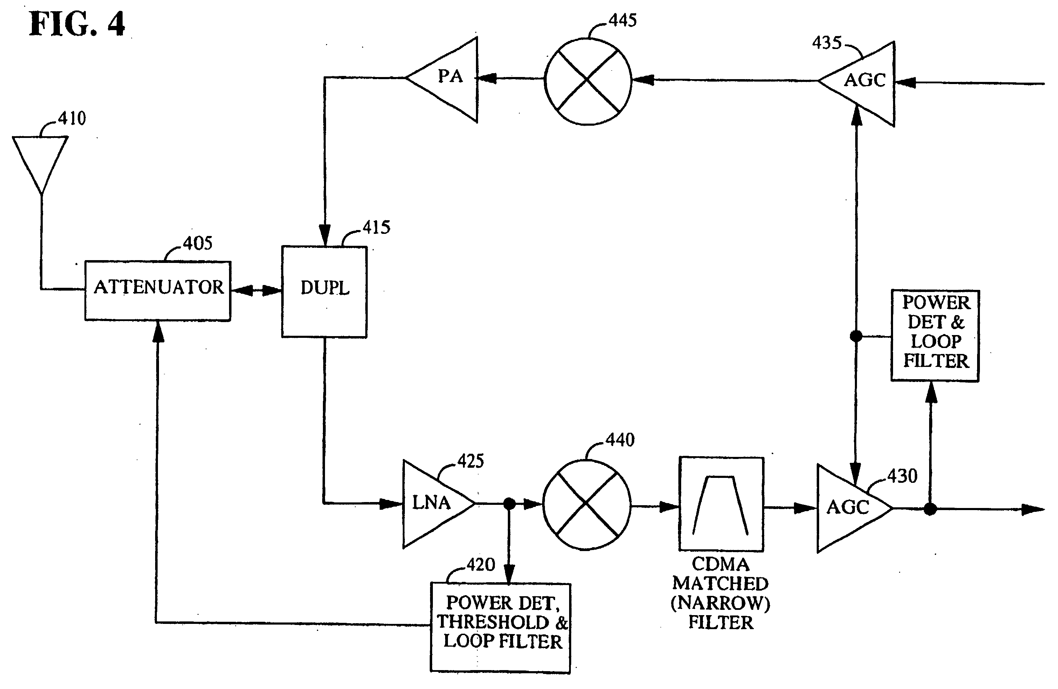

Yet another embodiment of the present invention is illustrated in FIG. 4. This embodiment uses an attenuator **405** between the antenna **410** and the duplexer **415**. The attenuation is controlled by the power detector **420** after the LNA **425**. The power detector **420** measures the received signal and jammer power, filters it, and compares it to a predetermined threshold. In this embodiment, the threshold is -25 dBm. When the combined signal and jammer power reaches this threshold, the attenuation caused by the attenuator **405** is increased. This adjustment can be either in digital fixed steps or continuously adjusted. The AGC **430** and **435** after the mixers **440** and **445** are adjusted in the same manner as in the apparatus of Figure 1.

An alternate embodiment of the apparatus of the present invention is illustrated in FIG. 7. This embodiment uses switches **701** and **702** to alter the front end gain. The actual switching level depends on the signal to noise requirements as a function of the signal level, or noise figure, for a particular CDMA radiotelephone design. Embodiments of the present invention can be used in an AMPS radiotelephone, however the switching characteristics will be changed to accommodate a different operating point.

This embodiment is comprised of an antenna **725** that receives and transmits radio signals. Receive and transmit paths in the radio are coupled to the antenna **725** through a duplexer **720** that separates the received signals from the transmitted signals.

A received signal is input to an LNA **703** that is coupled between two switches **701** and **702**. One switch **701** couples the LNA **703** to the duplexer **720** and the second switch **702** couples the LNA **703** to a band-pass filter **704**. In the preferred embodiment, the switches **701** and **702** are single-pole double-throw gallium arsenide switches.

The LNA **703** is coupled to one pole of each switch such that when both switches **701** and **702** are switched to those poles, the received signal is coupled to the LNA **703** and the amplified signal from the LNA **703** is output to the band-pass filter **704**. The band-pass filter **704** in this embodiment has a frequency band of 869-894 MHz. Alternate embodiments use different bands depending on the frequencies of the signals being received.

A bypass path **730** is coupled to the other pole of each switch. When the switches **701** and **702** are switched to their other poles, the received signal from the duplexer **720** bypasses the LNA **703** and is conducted directly to the band-pass filter **704**. In this embodiment, these switches **701** and **702** are controlled by the radiotelephone's microcontroller **740**. In an alternate embodiment, a separate controller is used to control the positions of these switches. Additionally, in other embodiments, attenuation (not shown) may be provided along bypass path **730** if desired.

After the band-pass filter **704** has filtered the received signal, the filtered signal is downconverted to a lower intermediate frequency (IF) for use by the rest of the radio. The down-conversion is done by mixing **705** the received signal with another signal having a frequency set by a phase locked loop 707 driving a voltage controlled oscillator 706. This signal is amplified 750 before being input to the mixer **705**.

The downconverted signal from the mixer **705** is input to the back end AGCs **708** and **709.** These AGCs **708** and **709** are used by the radiotelephone for closed loop power control, as is already well known in the art.

In the process of embodiments of the present invention, the microcontroller 740 monitors the power of the received signal. When the power exceeds -65 dBm, the microcontroller **740** instructs the switches **701** and **702** to switch to the bypass position, thus coupling the received signal directly to the bandpass filter **704**. By bypassing the LNA **703** gain, the intercept point for the receiver is increased proportionally by the reduction in gain in dB. Alternate embodiments use other circuitry and methods to monitor the power of the received signal.

An alternate embodiment of the process of the present invention continuously adjusts the front end gain. This embodiment uses a lower power threshold such as -25 dBm.

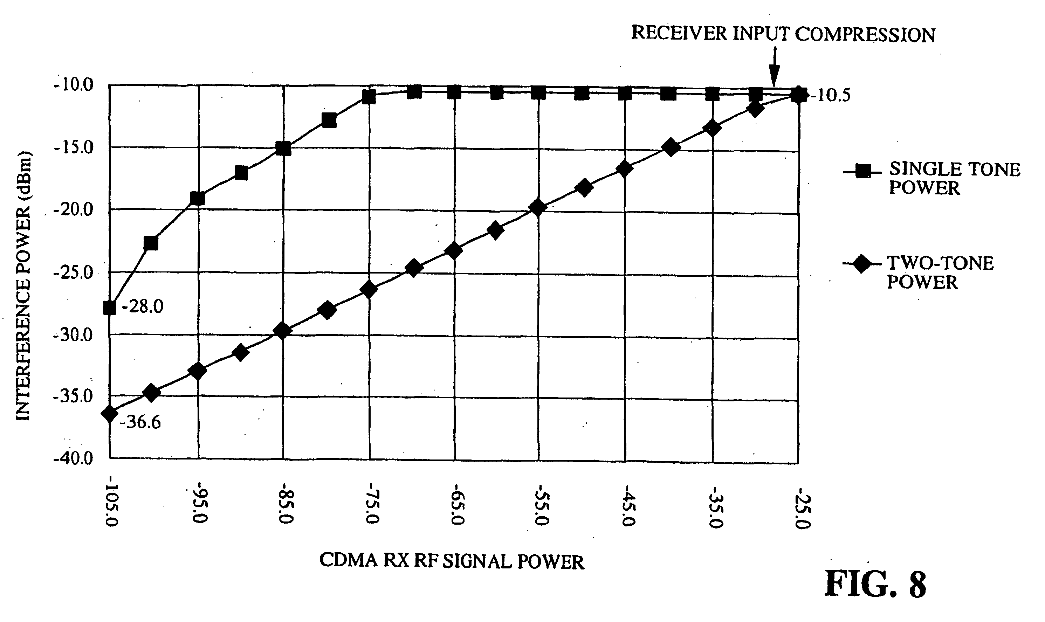

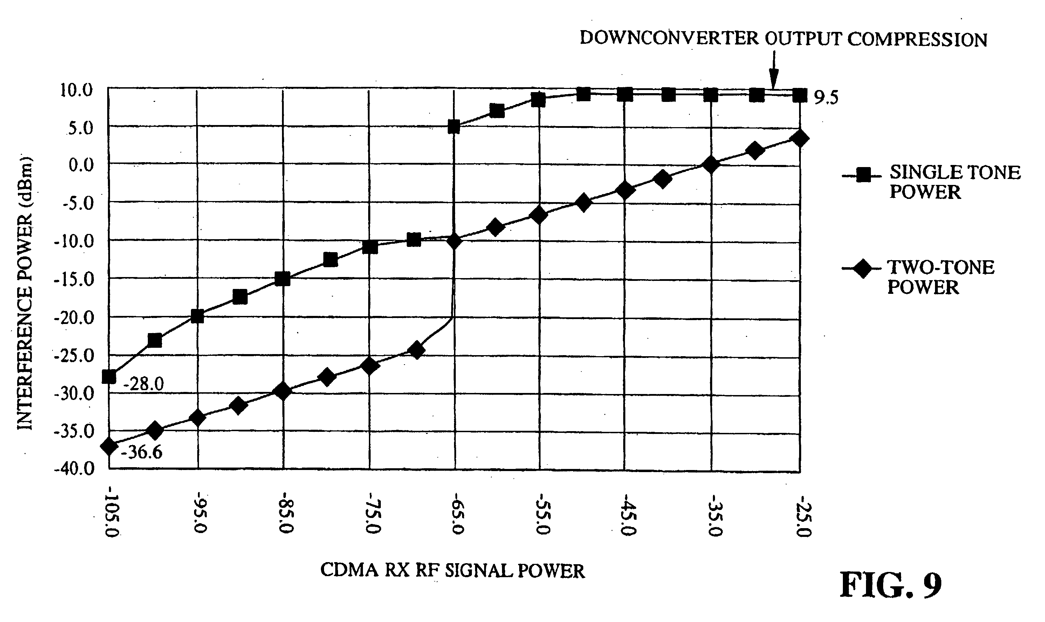

The plots of FIGs. 8 and 9 illustrate the benefits of the switchable gain embodiments of the present invention illustrated in FIGs. 7, 10, 11 and 12. FIG. 8 illustrates a plot of interference power versus radio frequency (RF) signal power for a typical radio that is not using the switchable gain apparatus. This plot shows that the maximum interference level is limited to the receiver input compression point at -10.5 dBm. Both the single and dual tone power curves are shown.

The plot of FIG. 9 shows the interference power received by the radio versus the radio frequency signal power received by the radio using the switchable gain embodiments of the method and apparatus of the present invention. It can be seen that at the -65 dBm point of the graph, the switches are switched to bypass the LNA gain thus allowing a greater interference power to be tolerated without affecting the RF signal power. Both the single tone and two tone power curves are shown.

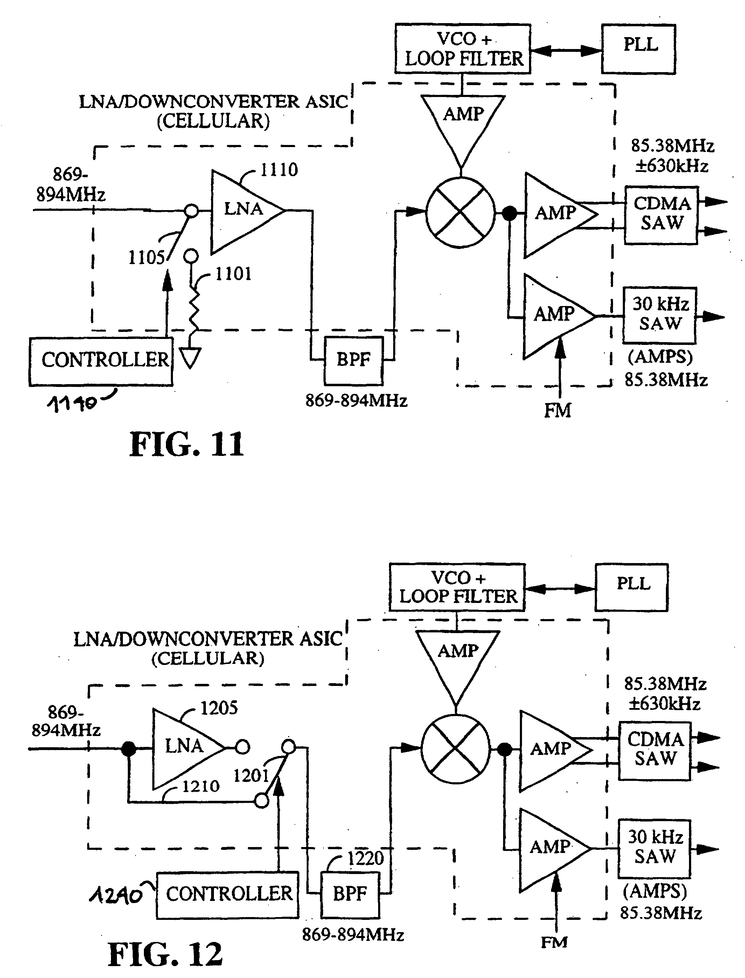

Another alternate embodiment of the apparatus of the present invention is illustrated in FIG. 10. This embodiment uses a single-pole single-throw switch **1001**. In this embodiment, the switch **1001** is switched to the bypass path **1010** by the controller **1020** when the received signal power reaches -65 dBm. This effectively shorts out the LNA **1002** gain, thus coupling the received signal directly to the band-pass filter **1003**.

Yet another alternate embodiment of the apparatus of the present invention is illustrated in FIG. 11. This embodiment uses a single-pole single-throw switch **1105** that, when closed, shorts the input of the LNA **1110** to ground through a resistor **1101**. This creates an impedance mismatch at the input causing the signal to attenuate, thus reducing the gain caused by the LNA **1110**. As in the above embodiments, the switch **1105** is closed when the input signal power reaches -65 dBm. The resistance required for the resistor **1101** is dependent on the amount of attenuation desired. This resistance will be different for different LNA's in alternate embodiments.

Still another embodiment of the apparatus of the present invention is illustrated in FIG. 12. This embodiment uses a single-pole double-throw switch **1201** at the output of the LNA **1205**. The LNA **1205** is connected to one pole of the switch **1201** and a bypass path **1210** is connected to the other pole. The input to the bypass path **1210** is connected to the input of the LNA **1205**. When the power level of the received RF signal reaches -65 dBm, the switch **1201** is thrown from the position coupling the LNA **1205** to the band-pass filter 1220 to the bypass path 1210. This couples the signal directly to the band-pass filter 1220, bypassing the gain of the LNA 1205.

In all of the above embodiments, the LNA can be powered down at the same time that it is bypassed by the switch or switches. This can be accomplished by connecting the LNA's power pin to a switch that is also controlled by the controller. Once the LNA is bypassed and is no longer used, power can be removed. This reduces the power consumption of the radio, thus increasing the talk and standby time for which the battery can be used.

$E_c/I_o$ detection may be used to determine when to adjust the front end gain. Alternatively, other quality measurements, such as $E_b/I_o$, may be used.

These ratios are quality measurements for digital communications system performance. The $E_b/I_o$ ratio expresses the energy per bit to the total interference spectral density of the channel while the $E_c/I_o$ ratio expresses the energy per CDMA chip relative to the total interference spectral density. $E_b/I_o$ can be considered a metric that characterizes the performance of one communication system over another; the smaller the required $E_b/I_o$ the more efficient is the system modulation and detection process for a given probability of error. Given that $E_c/I_o$ and received signal strength are readily available, the microcontroller can detect the presence of strong interference as a drop in $E_c/I_o$ while the AGC detector detects the increased interference. The microcontroller can lower the front end gain to improve interference immunity which would improve $E_c/I_o$ and lower the distortion products falling within the signal bandwidth.

When the signal quality goes above the $E_b/I_o$ or $E_c/I_o$ threshold, the front end gain is reduced. The gain adjustment can be accomplished using either the continuous adjustment method or the amplifier switching method, both described above.

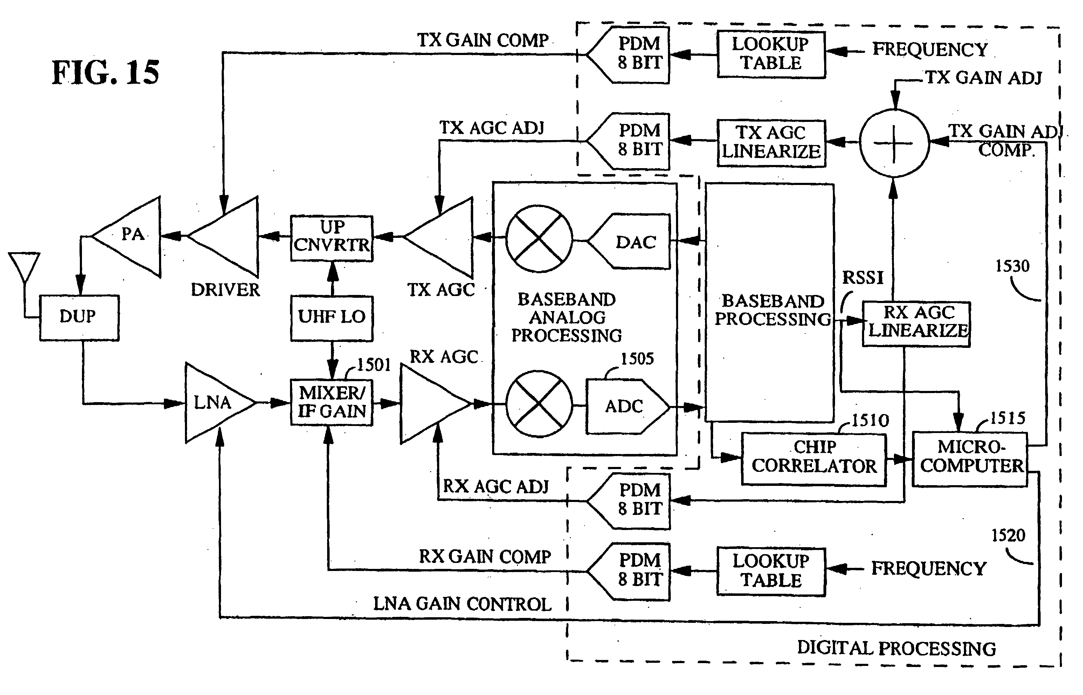

Alternatively, as illustrated in Figure 15, it would be possible to detect the signal power at IF or baseband instead of the combination of the signal and jammer power at RF. This approach is simpler in that there is only one power detector and AGC control loop.

The signal is first downconverted to baseband frequency 1501. This analog signal is then converted to a digital signal **1505** for further baseband processing including determining the received signal strength. The chip correlator **1510** determines the energy per chip with respect to the energy of all the non-coherent components. This information, along with the received signal strength indicator (RSSI) is used by the processor **1515** to determine the amount of gain adjustment for both the receive **1520** and transmit **1530** power.

Since the received signal power measurement includes both the signal and jammer power, the receive gain is increased only when both the signal level and the energy per chip drops. Since the RSSI is being changed, the transmit power must also be changed to compensate, thus enabling the open loop power control to operate properly. Thus, the processor adjusts the transmit gain whenever the receive gain is adjusted.

Erasures or signal power may be used to control the variable gain AGC. Alternatively, instead of controlling both transmit and receive power, only receiver power may be controlled.

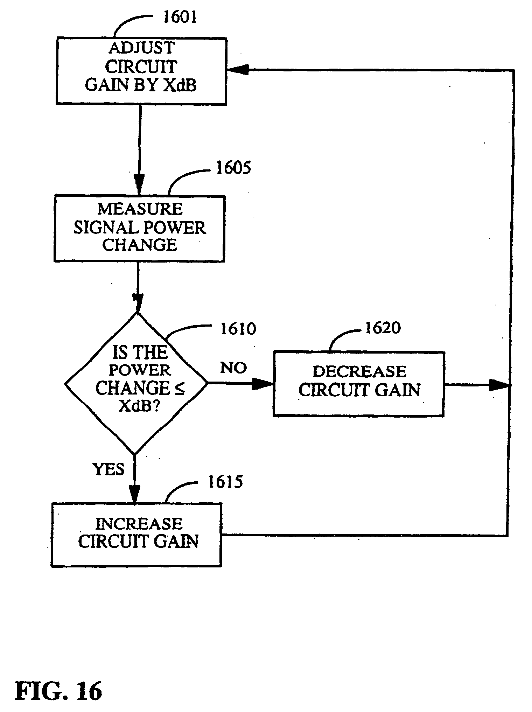

A process for controlling the gain of the above embodiments is illustrated in FIG. 16. This process is based on the relationship illustrated in the graph of FIG. 13. In FIG. 13, one can see that as the interference input power increases along the X axis, the intermodulation products (the lower curve) increase faster than the interference power. Therefore, X dB of attenuation applied at the input will result in a decrease of the IM3 intermodulation products by 3*X dB if interference is present at the receiver input.

Typically, intermodulation products don't fall into the IF section of the radio due to their low power. Intermodulation products outside of the IF section of the radio do not cause receiver performance problems. Thus, adjustment of the receiver gain is only necessary if the intermodulation products are of sufficient power to affect the IF signal.

Referring to FIG. 16, the process first adjusts the input gain **1601**. This gain adjustment is preferably 3 dB. However, other values of gain adjustment may be used such as the range of 1 dB - 6 dB. The receiver processing is then used to measure the change in the power of the received signal **1605**. In the preferred embodiment, the automatic gain control processing detects the IF signal power change. It is understood that measurement of the change in received signal power may be accomplished at the RF or baseband stages of the receiver as well.

If the signal power changes by approximately 3 dB, the CDMA signal is greater than the noise floor and there are no intermodulation products that might cause problems. Additional gain adjustment is not needed in this case, but increasing the gain will improve receiver sensitivity. IF signal power changes of approximately $(3 \pm 0.5)$ dB are still considered to be 3 dB.

If the IF signal power changes by less than 3 dB **1610**, the CDMA signal is less than the noise floor or there are no intermodulation products that might cause problems. In this case, the AGC is only seeing a small CDMA signal and noise. Therefore, it is necessary to increase the receiver circuit gain 1615 and thus increase the sensitivity of the receiver.

If the IF signal power changes by more than 3 dB, the intermodulation products are causing enough of a problem that additional gain adjustment is necessary 1620. In the preferred embodiment, if the input gain was changed by 3 dB the intermodulation products will change by 9 dB when large interference is present. In this case, the average gain may be decreased by a small amount (e.g., 3 dB) until the process determines that the intermodulation products are reduced to an acceptable level.

The process can be used continuously, checking for intermodulation products at a low rate. This rate is preferably ten times per second. Other embodiments use the process once per frame cycle. Still other embodiments use the process at other rates, such as upon detection of a significant error on the forward link.

An alternate embodiment of the method of the present invention is illustrated in FIG. 17. In this alternate embodiment, a "hold" time is introduced. As with the embodiment of FIG. 16, this alternate embodiment may be used to control the gain of any of the previous circuits described herein, using any of the previously disclosed power detectors, LNA's and controllers. Furthermore, it should be noted that although this alternate embodiment is disclosed with reference to an LNA, it is equally applicable to other types of amplifiers, whether fixed or variable gain.

The process begins in block **1702** with the LNA being "enabled", i.e. with the LNA amplifying the received RF signal. At decision diamond **1704**, it is determined whether the received power is greater than a disable threshold, as was previously discussed with reference to FIGs. 1-4. If the received power is not greater than the disable threshold, then the process returns to block **1702**.

The process remains with the LNA enabled until it is determined in decision diamond 1704 that the received power is indeed greater than the disable threshold, and the process moves to block 1706 where the LNA is "disabled", i.e. prevented from amplifying the received RF signal, for a predetermined time period. This predetermined time period may be referred to as a "hold" time which is desirable in order to limit the rate of switching the LNA in and out. By adding this "hold" time, the receive automatic gain control loops (see FIGs. 1-4 and 15) may be kept stable.

After the expiration of the predetermined time period (i.e. the hold time) of block 1706, the received power is again measured, and this time compared with an enable threshold in decision diamond **1708**. In the preferred embodiment, the enable threshold of decision diamond **1708** is less than the disable threshold of decision diamond **1704**, thereby providing hysteresis. However, this is not strictly required.

If the received power is greater than the enable threshold, then the received power is still too high, and the LNA remains disabled until the received power is less than the enable threshold. When the received power is less than the enable threshold as determined in decision diamond **1708**, then the process continues to decision diamond **1710** where it is determined whether significant intermodulation components are present. This determination is preferably made by switching in the LNA for a brief period and measuring the "shift" (i.e. the amount of AGC compensation) in the receive automatic gain control loops. As was discussed with reference to FIG. 16, the presence of significant intermodulation components would cause the received signal power to increase more than it would in the presence of the desired signal only. This extra increase in received signal power would cause the receive automatic gain control loops to provide a greater gain control signal to the AGC amplifiers.

If there are significant intermodulation components present as determined in decision diamond 1710, then the LNA is not re-enabled, but rather the process returns to block 1706 where the LNA remains disabled for the predetermined time period. However, if there are no significant intermodulation products present, then the front end gain may be increased to improve the receiver performance by re-enabling the LNA and returning to block **1702**.

In summary, the method enables a mobile radio to travel near antennas of different systems while increasing the radio's resistance to radio frequency interference from the other system. By decreasing the front end gain, the intercept point of the radio's receive circuitry increases so that the spurs from the other system's signals will not cause performance degradation of the receiver and demodulator.

The previous description of the preferred embodiments is provided to enable any person skilled in the art to make or use the present invention. The various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope as defined by the claims.

**Claims**

1. A method for adjusting the gain of a circuit, the circuit having a low noise amplifier (110, 235, 301, 425, 703, 1002, 1110, 1205) and receiving a signal having power, the method comprising:

   measuring (105, 210, 310, 420, 740, 1020, 1140, 1240) the power of said signal;
   comparing (105, 225, 310, 420, 740, 1020, 1140, 1240) said measured power of said signal with a first threshold;
   decreasing a gain of said low noise amplifier (110, 235, 301, 425, 703, 1002, 1110, 1205) for a predetermined time period if said measured signal power is greater than said first threshold;
   remeasuring (105, 210, 310, 420, 740, 1020, 1140, 1240) the power of said signal;
   comparing (135, 225, 310, 420, 740, 1020 1140, 1240) said remeasured power of said signal with a second threshold;
   varying said gain of said low noise amplifier (110, 235, 310, 425, 703, 1002, 1110, 1205);

   **characterised by**:

   detecting a change in said signal power;
   increasing said gain of said low noise amplifier (110, 235, 301, 425, 703, 1002, 1110, 1205) if said remeasured power of said signal is less than said second threshold and said detected change is less than a predetermined amount.

2. The method of claim 1, wherein said decreasing said gain includes switching said amplifier (110, 235, 301, 425, 703, 1002, 1110, 1205) to a low gain setting and wherein said increasing said gain includes switching said amplifier (110, 235, 301, 425, 703, 1002, 1110, 1205) to a high gain setting.

3. The method of claim 2, further comprising switching said amplifier (110, 235, 301, 425, 703, 1002, 1110, 1205) to said low gain setting for said predetermined time period if said remeasured power of said signal is not less than said second threshold or said detected change is not less than said predetermined amount.

4. The method of claim 3, wherein said amplifier (110, 235, 301, 425, 703, 1002, 1110, 1205) is a fixed gain amplifier and said low gain setting is substantially equal to zero gain.

5. The method of claim 1, wherein said circuit is a receive circuit and said amplifier (110, 235, 301, 425, 703, 1002, 1110, 1205) is a fixed gain amplifier, the method comprising:

   amplifying (1702) said received signal with said fixed gain amplifier;

   wherein:

   said measuring comprises measuring an amplified signal power of said amplified signal;
   said comparing (1704) said measured power comprises comparing (1704) said measured amplified signal power with said first threshold;
   said decreasing a gain of said amplifier comprises preventing (1706) said fixed gain amplifier from amplifying;
   said remeasuring comprises measuring a non-amplified signal power of said received signal after said first predetermined period has elapsed;
   said comparing said remeasured power comprises comparing (1708) said measured non-amplified signal power with said second threshold;
   said varying said gain of said amplifier comprises re-amplifying said received signal with said amplifier for a second predetermined period; said method further comprising:

      measuring a re-amplified signal power of said re-amplified signal; wherein
      said detecting a change in said signal power comprises detecting (1710) a difference between said measured non-amplified signal power and said re-amplified signal power; and
      said increasing said gain comprises repeating said amplifying if said measured non-amplified signal power is less than a second threshold and said detected difference is less than a predetermined amount.

6. The method of claim 5, further comprising preventing (1706) said fixed gain amplifier from amplifying said received signal for said first predetermined period if said measured non-amplified signal power is not less than said second threshold or said detected difference is not less than said predetermined amount.

7. The method of claim 3 or 6, wherein said first threshold is greater than said second threshold.

8. An apparatus for adjusting the gain of a circuit, the circuit having an amplifier (110, 235, 301, 425, 703, 1002, 1110, 1205) and receiving a signal having power, the apparatus comprising:

means operable to measure (105, 210, 310, 420, 740, 1020, 1140, 1240) the power of said signal;
means operable to compare (105, 225, 310, 420, 740, 1020, 1140, 1240) said measured power of said signal with a first threshold;
means operable to decrease a gain of said amplifier (110, 235, 310, 425, 703, 1002, 1110, 1205) for a predetermined time period if said measured signal power is greater than said first threshold;
means operable to remeasure (105, 210, 310, 420, 740, 1020, 1140, 1240) the power of said signal;
means operable to compare (105, 225, 310, 420, 740, 1020, 1140, 1240) said remeasured power of said signal with a second threshold;
means operable to vary said gain of said amplifier (110, 235, 310, 425, 703, 1002, 1110, 1205);

**characterised by**:

means operable to detect a change in said signal power;
means operable to increase said gain of said amplifier (110, 235, 310, 425, 703, 1002, 1110, 1205) if said remeasured power of said signal is less than said second threshold and said detected change is less than a predetermined amount.

9. The apparatus of claim 8, wherein said means operable to decrease said gain includes means operable to switch said amplifier (110, 235, 301, 425, 703, 1002, 1110, 1205) to a low gain setting and wherein said means operable to increase said gain includes means operable to switch said amplifier (110, 235, 301, 425, 703, 1002, 1110, 1205) to a high gain setting.

10. The apparatus of claim 9, further comprising means operable to switch said amplifier (110, 235, 301, 425, 703, 1002, 1110, 1205) to said low gain setting for said predetermined time period if said remeasured power of said signal is not less than said second threshold or said detected change is not less than said predetermined amount.

11. The apparatus of claim 10, wherein said amplifier (110, 235, 301, 425, 703, 1002, 1110, 1205) is a fixed gain amplifier and said low gain setting is substantially equal to zero gain.

12. The apparatus of claim 8, wherein said circuit is a receive circuit and said amplifier (110, 235, 301, 425, 703, 1002, 1110, 1205) is a fixed gain amplifier, the apparatus comprising:

means operable to amplify (1702) said received signal with said fixed gain amplifier;

wherein:

said means operable to measure comprises means operable to measure an amplified signal power of said amplified signal;
said means operable to compare (1704) said measured power comprises means operable to compare (1704) said measured amplified signal power with said first threshold;
said means operable to decrease a gain of said amplifier comprises means operable to prevent (1706) said fixed gain amplifier from amplifying;
said means operable to remeasure comprises means operable to measure a non-amplified signal power of said received signal after said first predetermined period has elapsed;
said means operable to compare said remeasured power comprises means operable to compare (1708) said measured non-amplified signal power with said second threshold;
said means operable to vary said gain of said amplifier comprises means operable to re-amplify said received signal with said amplifier for a second predetermined period; said apparatus further comprising:

> means operable to measure a re-amplified signal power of said re-amplified signal; wherein
> said means operable to detect a change in said signal power comprises means operable to detect (1710)
> a difference between said measured non-amplified signal power and said re-amplified signal power; and
> said means operable to increase said gain comprises means operable to repeat said amplifying if said
> measured non-amplified signal power is less than a second threshold and said detected difference is less
> than a predetermined amount.

13. The apparatus of claim 12, further comprising means operable to prevent (1706) said fixed gain amplifier from amplifying said received signal for said first predetermined period if said measured non-amplified signal power is not less than said second threshold or said detected difference is not less than said predetermined amount

14. The apparatus of claim 10 or 13, wherein said first threshold is greater than said second threshold.

**Patentansprüche**

1. Ein Verfahren zum Einstellen der Verstärkung bzw. des Gains einer Schaltung, wobei die Schaltung einen Niedrigrauschverstärker (110, 235, 301, 425, 703, 1002, 1110, 1205) besitzt und ein Signal mit einer Leistung empfängt, wobei das Verfahren Folgendes aufweist:

> Messen (105, 210, 310, 420, 740, 1020, 1140, 1240) der Leistung bzw. Energie des Signals;
> Vergleichen (105, 225, 310, 420, 740, 1020, 1140, 1240) der gemessenen Leistung des Signals mit einem ersten Schwellenwert;
> Senken einer Verstärkung des Niedrigrauschverstärkers (110, 235, 301, 425, 703, 1002, 1110, 1205) und zwar für eine vorbestimmte Zeitperiode, wenn die gemessene Signalleistung größer ist als der erste Schwellenwert;
> wiederholtes Messen (105, 210, 310, 420, 740, 1020, 1140, 1240) der Leistung des Signals;
> Vergleichen (105, 225, 310, 420, 740, 1020, 1140, 1240) der erneut gemessenen Leistung des Signals mit einem zweiten Schwellenwert;
> Variieren der Verstärkung des Niedrigrauschverstärkers (110, 235, 301, 425, 703, 1002, 1110, 1205); **gekennzeichnet durch** die folgenden Schritte:
>
> > Detektieren einer Veränderung in der Signalleistung;
> > Erhöhen der Verstärkung des Niedrigrauschverstärkers (110, 235, 301, 425, 703, 1002, 1110, 1205), wenn die erneut gemessene Leistung des Signals geringer ist als der zweite Schwellenwert und die detektierte Veränderung kleiner ist als ein vorbestimmter Betrag.

2. Das Verfahren nach Anspruch 1, wobei das Senken der Verstärkung das Schalten des Verstärkers (110, 235, 301, 425, 703, 1002, 1110, 1205) auf eine Niedrigverstärkungseinstellung beinhaltet und wobei das Erhöhen der Verstärkung das Schalten des Verstärkers (110, 235, 301, 425, 703, 1002, 1110, 1205) auf eine Hochverstärkungseinstellung beinhaltet.

3. Das Verfahren nach Anspruch 2, das weiterhin aufweist, dass der Verstärker (110, 235, 301, 425, 703, 1002, 1110, 1205) auf die Niedrigverstärkungseinstellung für die vorbestimmte Zeitperiode geschaltet wird, wenn die erneut gemessene Leistung des Signals nicht weniger als ein zweiter Schwellenwert ist oder die detektierte Veränderung nicht weniger als der vorbestimmte Betrag ist.

4. Das Verfahren nach Anspruch 3, wobei der Verstärker (110, 235, 301, 425, 703, 1002, 1110, 1205) ein Verstärker mit festgelegter Verstärkung ist und die Niedrigverstärkungseinstellung im Wesentlichen gleich einer Null-Verstärkung ist.

5. Das Verfahren nach Anspruch 1, wobei die Schaltung eine Empfangsschaltung und der Verstärker (110, 235, 301, 425, 703, 1002, 1110, 1205) ein Verstärker mit festgelegter Verstärkung ist, wobei das Verfahren Folgendes aufweist:

> Verstärken (1702) des empfangenen Signals mit dem Verstärker mit festgelegter Verstärkung;

wobei:

das Messen ein Messen einer verstärkten Signalleistung des verstärkten Signals aufweist;

das Vergleichen (1704) der gemessenen Leistung ein Vergleichen (1704) der gemessenen verstärkten Signalleistung bzw. der gemessenen Leistung des verstärkten Signals mit dem ersten Schwellenwert aufweist;

das Senken einer Verstärkung des Verstärkers beinhaltet, dass der Verstärker mit festgelegter Verstärkung davon abgehalten wird (1706) zu verstärken;

das erneute Messen ein Messen einer nicht-verstärkten Signalleistung des empfangenen Signals nach dem Ablauf der ersten vorbestimmten Zeitperiode aufweist;

das Vergleichen der erneut gemessenen Leistung ein Vergleichen (1708) der gemessenen nicht-verstärkten Signalleistung mit dem zweiten Schwellenwert aufweist;

das Verändern der Verstärkung des Verstärkers ein erneutes Verstärken des empfangenen Signals mit dem Verstärker, und zwar für eine zweite vorbestimmte Zeitperiode, aufweist; wobei das Verfahren weiterhin die folgenden Schritte aufweist:

Messen einer erneut verstärkten Signalleistung des erneut verstärkten Signals; wobei das Detektieren eine Veränderung in der Signalleistung ein Detektieren (1710) einer Differenz zwischen der gemessenen, nicht verstärkten Signalleistung und der erneut verstärkten Signalleistung aufweist; und

das Erhöhen der Verstärkung ein Wiederholen der Verstärkung aufweist, wenn die gemessene, nicht-verstärkte Signalleistung kleiner als ein zweiter Schwellenwert ist und die detektierte Differenz geringer als ein vorbestimmter Betrag ist.

6. Das Verfahren nach Anspruch 5, das weiterhin den Schritt aufweist, dass verhindert wird (1706), dass der Verstärker mit festgelegter Verstärkung das empfangene Signal für die erste vorbestimmte Periode verstärkt, wenn die gemessene, nicht-verstärkte Signalleistung nicht weniger als der zweite Schwellenwert ist oder die detektierte Differenz nicht weniger als der vorbestimmte Betrag ist.

7. Das Verfahren nach Anspruch 3 oder 6, wobei der erste Schwellenwert größer als der zweite Schwellenwert ist.

8. Eine Vorrichtung zur Einstellung der Verstärkung einer Schaltung, wobei die Schaltung einen Verstärker (110, 235, 301, 425, 703, 1002, 1110, 1205) hat und ein Signal mit einer Leistung empfängt, wobei die Vorrichtung Folgendes aufweist:

Mittel betätigbar zum Messen (105, 210, 310, 420, 740, 1020, 1140, 1240) der Energie des Signals;

Mittel betätigbar zum Vergleichen (105, 225, 310, 420, 740, 1020, 1140, 1240) der gemessenen Leistung des Signals mit einem ersten Schwellenwert;

Mittel betätigbar zum Senken einer Verstärkung des Verstärkers (110, 235, 310, 425, 703, 1002, 1110, 1205) für eine vorbestimmte Zeitperiode lang, wenn die gemessene Signalleistung größer ist als der erste Schwellenwert;

Mittel betätigbar zum erneuten Messen (105, 210, 310, 420, 740, 1020, 1140, 1240) der Energie des Signals;

Mittel betätigbar zum Vergleichen (105, 225, 310, 420, 740, 1020, 1140, 1240) der erneut gemessenen Leistung des Signals mit einem zweiten Schwellenwert;

Mittel betätigbar zum Variieren der Verstärkung des Verstärkers (110, 235, 310, 425, 703, 1002, 1110, 1205), **gekennzeichnet durch**

Mittel betätigbar zum Detektieren einer Veränderung in der Signalleistung; Mittel betätigbar zum Erhöhen der Verstärkung des Verstärkers (110, 235, 310, 425, 703, 1002, 1110, 1205), wenn die erneut gemessene Leistung des Signals kleiner als der zweite Schwellenwert ist und die detektierte Veränderung kleiner als ein vorbestimmter Betrag ist.

9. Die Vorrichtung nach Anspruch 8, wobei die Mittel betätigbar zum Senken der Verstärkung Mittel beinhalten, die betätigbar sind um den Verstärker (110, 235, 301, 425, 703, 1002, 1110, 1205) auf eine Niedrigverstärkungseinstellung zu schalten und wobei die Mittel betätigbar zur Erhöhung den Verstärkung Mittel beinhalten, die betätigbar sind zum Schalten des Verstärkers (110, 235, 301, 425, 703, 1002, 1110, 1205) auf bzw. in eine Hochverstärkungseinstellung.

10. Die Vorrichtung nach Anspruch 9, die weiterhin Mittel aufweist, die betätigbar sind um den Verstärker (110, 235, 301, 425, 703, 1002, 1110, 1205) auf die Niedrigverstärkungseinstellung für eine vorbestimmte Zeitperiode lang zu schalten, und zwar wenn die erneut gemessene Leistung des Signals nicht kleiner als der zweite Schwellenwert ist, oder die detektierte Veränderung nicht kleiner als der vorbestimmte Betrag ist.

11. Die Vorrichtung nach Anspruch 10, wobei der Verstärker (110, 235, 301, 425, 703, 1002, 1110, 1205) ein Verstärker mit festgelegter Verstärkung ist und die Niedrigverstärkungseinstellung im Wesentlichen gleich einer Null-Verstärkung ist.

12. Die Vorrichtung nach Anspruch 8, wobei die Schaltung eine Empfangsschaltung ist und der Verstärker (110, 235, 301, 425, 703, 1002, 1110, 1205) ein Verstärker mit festgelegter Verstärkung ist, wobei die Vorrichtung Folgendes aufweist:

Mittel betätigbar um das empfangene Signal mit dem Verstärker mit festgelegter Verstärkung zu verstärken (1702);

wobei:

die Mittel betätigbar zum Messen Mittel aufweisen, die betätigbar sind um eine verstärkte Signalleistung des verstärkten Signals zu messen;

wobei die Mittel betätigbar zum Vergleichen (1704) der gemessenen Leistung Mittel aufweisen, die betätigbar sind um die gemessene verstärkte Signalleistung bzw. gemessene Leistung des verstärkten Signals mit dem ersten Schwellenwert zu vergleichen;
die Mittel betätigbar zum Senken einer Verstärkung des Verstärkers Mittel aufweisen, die betätigbar sind um den Verstärker mit festgelegter Verstärkung von einer Verstärkung abzuhalten (1706);
die Mittel betätigbar zur erneuten Messung Mittel aufweisen, die betätigbar sind um eine nicht-verstärkte Signalleistung des empfangenen Signals zu messen, und zwar nachdem die erste vorbestimmte Periode abgelaufen ist;
die Mittel betätigbar zum Vergleichen der erneut gemessenen Leistung Mittel aufweisen, die betätigbar sind zum Vergleichen (1708) der gemessenen, nicht-verstärkten Signalleistung mit dem zweiten Schwellenwert;
die Mittel betätigbar zum Variieren der Verstärkung des Verstärkers Mittel aufweisen, die betätigbar sind um das empfangene Signal durch den Verstärker erneut zu verstärken, und zwar eine zweite vorbestimmte Periode lang;
wobei die Vorrichtung weiterhin Folgendes aufweist:

Mittel, die betätigbar sind um eine erneute verstärkte Signalleistung des erneut verstärkten Signals zu messen; wobei
die Mittel betätigbar um eine Veränderung in der Signalleistung zu detektieren Mittel aufweisen, die betätigbar sind um eine Differenz zwischen der gemessenen, nicht-verstärkten Signalleistung und der erneut verstärkten Signalleistung zu detektieren; und
die Mittel betätigbar zum Erhöhen der Verstärkung Mittel aufweisen, die betätigbar sind um die Verstärkung zu wiederholen, wenn die gemessene, nicht-verstärkte Signalleistung geringer als ein zweiter Schwellenwert ist und die detektierte Differenz geringer ist als ein vorbestimmter Betrag.

13. Die Vorrichtung nach Anspruch 12, die weiterhin Mittel aufweist, die betätigbar sind um den Verstärker mit festgelegter Verstärkung von einer Verstärkung des empfangenen Signals abzuhalten, und zwar für eine erste vorbestimmte Periode lang, wenn die gemessene, nicht-verstärkte Signalleistung bzw. die gemessene Signalleistung des nicht-verstärkten Signals nicht kleiner als der zweite Schwellenwert ist oder die detektierte Differenz nicht kleiner als der vorbestimmte Betrag ist.

14. Die Vorrichtung nach Anspruch 10 oder 13, wobei der erste Schwellenwert größer ist als der zweite Schwellenwert.

**Revendications**

1. Procédé pour régler le gain d'un circuit, le circuit ayant un amplificateur à faible bruit (110, 235, 301, 425, 703, 1002, 1110, 1205) et pour recevoir un signal porteur de puissance, le procédé comprenant les étapes consistant à :

- mesurer (105, 210, 310, 420, 740, 1020, 1140, 1240) la puissance dudit signal,
- comparer (105, 225, 310, 420, 740, 1020, 1140, 1240) ladite puissance mesurée dudit signal avec un premier seuil ;
- diminuer un gain dudit amplificateur à faible bruit (110, 235, 301, 425, 703, 1002, 1110, 1205) pour un laps de temps prédéterminé, si ladite puissance de signal mesurée est supérieure audit premier seuil ;

- remesurer (105, 210, 310, 420, 740, 1020, 1140, 1240) la puissance dudit signal ;
- comparer (105, 225, 310, 420, 740, 1020, 1140, 1240) ladite puissance remesurée dudit signal avec un deuxième seuil ;
- amener ledit gain dudit amplificateur à faible bruit (110, 235, 301, 425, 703, 1002, 1110, 1205) à varier ;

   **caractérisé par** les étapes consistant à :

- détecter un changement dans ladite puissance de signal ;
- augmenter ledit gain dudit amplificateur à faible bruit (110, 235, 301, 425, 703, 1002, 1110, 1205) si ladite puissance remesurée dudit signal est inférieure audit deuxième seuil et si ledit changement détecté est inférieur à une valeur prédéterminée.

2. Procédé selon la revendication 1, dans lequel ladite diminution dudit gain comporte la commutation dudit amplificateur (110, 235, 301, 425, 703, 1002, 1110, 1205) sur un réglage à faible gain et dans lequel ladite augmentation dudit gain comporte la commutation dudit amplificateur (110, 235, 301, 425, 703, 1002, 1110, 1205) sur un réglage à grand gain.

3. Procédé selon la revendication 2, comprenant en outre la commutation dudit amplificateur (110, 235, 301, 425, 703, 1002, 1110, 1205) sur ledit réglage à faible gain pour ledit laps de temps prédéterminé, si ladite puissance remesurée dudit signal n'est pas inférieure audit deuxième seuil ou si le changement détecté n'est pas inférieur à ladite valeur prédéterminée.

4. Procédé selon la revendication 3, dans lequel ledit amplificateur (110, 235, 301, 425, 703, 1002, 1110, 1205) est un amplificateur à gain fixe et si ledit réglage à faible gain est sensiblement égal à un gain nul.

5. Procédé selon la revendication 1, dans lequel ledit circuit est un circuit de réception et ledit amplificateur (110, 235, 301, 425, 703, 1002, 1110, 1205) est un amplificateur à gain fixe, le procédé comprenant l'étape consistant à :

- amplifier (1702) ledit signal reçu avec ledit amplificateur à gain fixe ;

   dans lequel :

- ladite mesure comprend la mesure d'une puissance de signal amplifié dudit signal amplifié ;
- ladite comparaison (1704) de ladite puissance mesurée comprend la comparaison (1704) de ladite puissance de signal amplifié mesurée avec ledit premier seuil ;
- ladite diminution d'un gain dudit amplificateur comprend le fait d'empêcher (1706) ledit amplificateur à gain fixe d'amplifier ;
- ladite remesure comprend la mesure d'une puissance de signal non amplifié dudit signal reçu, après que ladite première période prédéterminée se sera écoulée ;
- ladite comparaison de ladite puissance remesurée comprend la comparaison (1708) de ladite puissance de signal non amplifié mesurée avec ledit deuxième seuil ;
- ladite variation dudit gain dudit amplificateur comprend une ré-amplification dudit signal reçu avec ledit amplificateur pendant une deuxième période prédéterminée ; ledit procédé comprenant, en outre, l'étape consistant à :

   - mesurer une puissance de signal ré-amplifié dudit signal ré-amplifié, dans lequel
   - ladite détection d'un changement dans ladite puissance de signal comprend la détection (1710) d'une différence entre ladite puissance de signal non amplifié mesurée et ladite puissance de signal ré-amplifié et
   - ladite augmentation dudit gain comprend la répétition de ladite amplification si ladite puissance de signal non amplifié mesurée est inférieure à un deuxième seuil et si ladite différence détectée est inférieure à une valeur prédéterminée.

6. Procédé selon la revendication 5, comprenant en outre le fait d'empêcher (1706) ledit amplificateur à gain fixe d'amplifier ledit signal reçu pendant ladite première période prédéterminée, si ladite puissance de signal non amplifié mesurée n'est pas inférieure audit deuxième seuil ou si ladite différence détectée n'est pas inférieure à ladite valeur prédéterminée.

**7.** Procédé selon la revendication 3 ou 6, dans lequel ledit premier seuil est supérieur audit deuxième seuil.

**8.** Appareil pour régler le gain d'un circuit, le circuit ayant un amplificateur (110, 235, 301, 425, 703, 1002, 1110, 1205) et pour recevoir un signal porteur de puissance, l'appareil comprenant :

- un moyen apte à mesurer (105, 210, 310, 420, 740, 1020, 1140, 1240) la puissance dudit signal ;
- un moyen apte à comparer (105, 225, 310, 420, 740, 1020, 1140, 1240) ladite puissance mesurée dudit signal avec un premier seuil ;
- un moyen apte à diminuer un gain dudit amplificateur (110, 235, 301, 425, 703, 1002, 1110, 1205) pendant un laps de temps prédéterminé, si ladite puissance de signal mesurée est supérieure audit premier seuil ;
- un moyen apte à remesurer (210, 225, 310, 420, 740, 1020, 1140, 1240) la puissance dudit signal ;
- un moyen apte à comparer (105, 225, 310, 420, 740, 1020, 1140, 1240) ladite puissance remesurée dudit signal avec un deuxième seuil ;
- un moyen apte à amener ledit gain dudit amplificateur (110, 235, 310, 425, 703, 1002, 1110, 1205) à varier ;

   **caractérisé par** :

- un moyen apte à détecter un changement dans ladite puissance de signal ;
- un moyen apte à augmenter ledit gain dudit amplificateur (110, 235, 301, 425, 703, 1002, 1110, 1205), si ladite puissance remesurée dudit signal est inférieure audit deuxième seuil et si le changement détecté est inférieur à une valeur prédéterminée.

**9.** Appareil selon la revendication 8, dans lequel ledit moyen, apte à diminuer ledit gain, comporte un moyen, apte à commuter ledit amplificateur (110, 235, 301, 425, 703, 1002, 1110, 1205) sur un réglage à faible gain et dans lequel ledit moyen, apte à augmenter ledit gain comporte un moyen, apte à commuter ledit amplificateur (110, 235, 301, 425, 703, 1002, 1110, 1205) sur un réglage à grand gain.

**10.** Appareil selon la revendication 9, comprenant en outre un moyen, apte à commuter ledit amplificateur (110, 235, 301, 425, 703, 1002, 1110, 1205) sur ledit réglage à faible gain pendant ledit laps de temps prédéterminé, si ladite puissance remesurée dudit signal n'est pas inférieure audit deuxième seuil ou si ledit changement détecté n'est pas inférieur à ladite valeur prédéterminée.

**11.** Appareil selon la revendication 10, dans lequel ledit amplificateur (110, 235, 301, 425, 703, 1002, 1110, 1205) est un amplificateur à gain fixe et si ledit réglage à faible gain est sensiblement égal à un gain nul.

**12.** Appareil selon la revendication 8, dans lequel ledit circuit est un circuit de réception et ledit amplificateur (110, 235, 301, 425, 703, 1002, 1110, 1205) est un amplificateur à gain fixe, l'appareil comprenant :

- un moyen, apte à amplifier (1702) ledit signal reçu avec ledit amplificateur à gain fixe ;

   dans lequel :

- ledit moyen, apte à remesurer, comprend un moyen, apte à mesurer une puissance de signal amplifié dudit signal amplifié ;
- ledit moyen, apte à comparer (1704) ladite puissance mesurée comprend un moyen, apte à comparer (1704) ladite puissance de signal amplifié mesurée avec ledit premier seuil ;
- ledit moyen, apte à diminuer un gain dudit amplificateur comprend un moyen, apte à empêcher (1706) ledit amplificateur à gain fixe d'amplifier ;
- ledit moyen, apte à remesurer, comprend un moyen, apte à mesurer une puissance de signal non amplifié dudit signal reçu, après que ladite première période prédéterminée se sera écoulée ;
- ledit moyen, apte à comparer ladite puissance remesurée, comprend un moyen, apte à comparer (1708) ladite puissance de signal non amplifié mesurée avec ledit deuxième seuil ;
- ledit moyen, apte à faire varier ledit gain dudit amplificateur, comprend un moyen, apte à ré-amplifier ledit signal reçu avec ledit amplificateur, pendant une deuxième période prédéterminée ; ledit appareil comprenant en outre :

   - un moyen, apte à mesurer une puissance de signal ré-amplifié dudit signal ré-amplifié, dans lequel :

- ledit moyen, apte à détecter un changement dans ladite puissance de signal, comprend un moyen, apte à détecter (1710) une différence entre ladite puissance de signal non amplifié mesurée et ladite puissance de signal ré-amplifié et
- ledit moyen, apte à augmenter ledit gain comprend un moyen, apte à répéter ladite amplification, si ladite puissance de signal non amplifié mesurée est inférieure à un deuxième seuil et si la différence détectée est inférieure à une valeur prédéterminée.

13. Appareil selon la revendication 12, comprenant en outre un moyen, apte à empêcher (1706) ledit amplificateur à gain fixe d'amplifier ledit signal reçu, pendant ladite première période prédéterminée, si ladite puissance de signal non amplifié mesurée n'est pas inférieure audit deuxième seuil ou si ladite différence détectée n'est pas inférieure à ladite valeur prédéterminée.

14. Appareil selon la revendication 10 ou 13, dans lequel ledit premier seuil est supérieur audit deuxième seuil.

FIG. 1

EP 1 020 041 B1

FIG. 2

ANTENNA

DUPL

PA 230

AGC 230

240

AGC 220

POWER DET & LOOP FILTER 210

THRESHOLD 225

LNA

AGC 235

245

CDMA MATCHED (NARROW) FILTER 205

AGC 215

EP 1 020 041 B1

# FIG. 3

EP 1 020 041 B1

ANTENNA

DUPL

PA

AGC

POWER DET, THRESHOLD & LOOP FILTER

310

AGC  301

LNA  305

CDMA MATCHED (NARROW) FILTER

AGC

AGC

POWER DET & LOOP FILTER

# FIG. 4

FIG. 5

# FIG. 6

## FIG. 7

SIGNAL TO BE TRANSMITTED

725

PA

720

DUPLEXER

LNA/DOWNCONVERTER ASIC
(CELLULAR)

706
VCO +
LOOP FILTER

707
PLL

AMP
750

869-894MHz

703
LNA

701    730    702

705

AMP    708

85.38MHz
±630kHz

710
CDMA
SAW

740
CONTROLLER

704
BPF

AMP    709

711
30 kHz
SAW

FM

(AMPS)
85.38MHz

## FIG. 10

VCO +
LOOP FILTER

PLL

LNA/DOWNCONVERTER ASIC
(CELLULAR)

AMP

869-894MHz

1002
LNA

1001    1010

85.38MHz
±630kHz

AMP

CDMA
SAW

1020
CONTROLLER

1003
BPF

AMP

30 kHz
SAW

869-894MHz

FM

(AMPS)
85.38MHz

FIG. 8

FIG. 9

EP 1 020 041 B1

VCO +
LOOP FILTER ⟷ PLL

LNA/DOWNCONVERTER ASIC
(CELLULAR)

AMP

869-894MHz

1110

LNA

1105

1101

CONTROLLER

1110

BPF

869-894MHz

85.38MHz
±630kHz

AMP

CDMA
SAW

AMP

30 kHz
SAW

FM

(AMPS)
85.38MHz

## FIG. 11

VCO +
LOOP FILTER ⟷ PLL

LNA/DOWNCONVERTER ASIC
(CELLULAR)

AMP

869-894MHz

1205

LNA

1210

1201

1240    CONTROLLER

1220

BPF

869-894MHz

85.38MHz
±630kHz

AMP

CDMA
SAW

AMP

30 kHz
SAW

FM

(AMPS)
85.38MHz

## FIG. 12

Output, IM3 Distortion, and IIP3 vs. Total Input Power

**FIG. 13**

EP 1 020 041 B1

**FIG. 14**

FIG. 15

**FIG. 16**

```
                                              ┌─────────────┐  ⌐1702
                                              │     LNA     │
                                    ┌────────▶ │   ENABLED   │
                                    │         └─────────────┘
                                    │                │
                                    │                ▼
                                    │              ╱╲
                                    │             ╱  ╲
                                    │            ╱ IS ╲  ⌐1704
                                    │           ╱RECEIVE╲
                           NO       │          ╱ POWER   ╲
                                    └─────────╱ >DISABLE  ╲
                                              ╲ THRESHOLD?╱
                                               ╲         ╱
                                                ╲       ╱
                                                 ╲     ╱
                                                  ╲   ╱
                                                   ╲ ╱
                                                  YES│
                                                    ▼
                                         ┌──────────────────────┐  ⌐1706
                                         │ DISABLE LNA AND WAIT  │
                                         │ PREDETERMINED  TIME   │◀──┐
                                         │       PERIOD          │   │
                                         └──────────────────────┘   │
                                                    │               │
                                                    ▼◀──────┐       │
                                                   ╱╲       │       │
                                                  ╱  ╲      │       │
                                                 ╱ IS ╲ ⌐1708       │
                                                ╱RECEIVE╲   │       │
                                               ╱ POWER   ╲  NO       │
                                               ╲<ENABLE  ╱──┘       │
                                                ╲THRESHOLD?╱         │
                                                 ╲       ╱           │
                                                  ╲     ╱            │
                                                   ╲   ╱             │
                                                 YES│ ╱              │
                                                    ▼                │
                                                   ╱╲   ⌐1710        │
                                                  ╱  ╲               │
                                                 ╱ ARE ╲             │
                                        NO      ╱SIGNIFICANT╲   YES   │
                                        ┌──────╱ INTERMOD    ╲───────┘
                                               ╲COMPONENTS  ╱
                                                ╲PRESENT?  ╱
                                                 ╲        ╱
                                                  ╲      ╱
                                                   ╲    ╱
```

FIG. 17